# EUROPEAN PATENT APPLICATION

(11) **EP 4 835 505 A1**
(43) Date of publication of application: **04.11.2026**
(21) Application number: 26173706.8
(22) Date of filing: 21.04.2026
(51) Int. Cl.: G01R 31/392, H02J 7/00, H02J 7/84, H02J 7/90

(54) **BATTERY CHARGER AND METHOD**

(30) Priority: 29.04.2025 SE 2550409
(71) Applicant: CTEK Sweden AB, 791 42 Falun (SE)
(72) Inventor: DALSGAARD, Henning, 7800 Skive (DK); GJERRILD, Niels-Christian, 9000 Aalborg (DK)
(74) Representative: Brann AB

(57) **Abstract**

The disclosure relates to a method performed by a battery charger configured to charge a battery, the method comprising: measuring a first voltage amplitude (Ubatt) over poles of the battery, obtaining a second voltage amplitude (Ustart) and a first current amplitude, controlling generation of a pulse within a cycle period (Tcycle) to poles of the battery, the pulse having the second voltage amplitude (Ustart) and being limited by the first current amplitude, measuring a third voltage amplitude (Usave) and a second current amplitude at the end of the generated pulse, determining a differential voltage as a difference between the second voltage amplitude (Usave) and the first voltage amplitude (Ubatt), evaluating a state of the battery as being in a recoverable state, in a normal state or in a damaged state by evaluating the first voltage amplitude (Ubatt) and the differential voltage, and charging the battery based on the evaluated state.

## Description

### Technical Field

The present invention relates to a battery charger configured to automatically repair a discharged battery. In particular to repair a discharged Lead Acid battery.

### Background

A battery is often used in a craft, such as a vehicle, caravan or a boat for various purposes. A battery typically comprises two battery poles or terminals where the battery voltage is delivered. The battery typically comprises multiple cells internally connected within the battery to generate the desired battery voltage at the battery terminals.

When a charging current is delivered to a battery, the ability of the different battery cells to accept the charging current to increase its state of charge, SOC, may vary.

At some point, the battery may be aged and/or so deeply discharged such that the battery ability to accept the charging current is severely reduced or lost. Alternatively, the battery may then accept an unnaturally high charging current causing excessive heat or even an explosion.

In a worst-case scenario, a large number of new batteries are stored without proper maintenance charging, and are rendered useless without being put into use even once. This does not only represent a financial waste, but is also a waste of earth's limited resources.

A drawback with conventional battery chargers is that they are unable to address such problems and provide charge to batteries in a state described above.

Thus, there is a need for an improved battery charger and method.

### Objects of the invention

An objective of embodiments of the present invention is to provide a solution which mitigates or solves the drawbacks and problems described above.

### Summary of the invention

The above and further objectives are achieved by the subject matter described herein. Further advantageous implementation forms of the invention are described herein. The invention is set out in the appended claims. The scope of the invention is defined by the claims which are incorporated into this section by reference.

According to a first aspect of the invention the object of the invention is achieved by a method performed by a battery charger configured to charge a battery, the method comprising: measuring a first voltage amplitude over poles of the battery, obtaining a second voltage amplitude and a first current amplitude, controlling generation of a pulse within a cycle period to poles of the battery, the pulse having the second voltage amplitude and being limited by the first current amplitude, measuring a third voltage amplitude and a second current amplitude at the end of the generated pulse, determining a differential voltage as a difference between the second voltage amplitude and the first voltage amplitude, evaluating a state of the battery as being in a recoverable state, in a normal state or in a damaged state by evaluating the first voltage amplitude and the differential voltage, and charging the battery based on the evaluated state.

This has the advantage batteries that otherwise would be discarded, can be returned to good health. This represents significant savings for the environment as well as saving of operational costs.

In one embodiment, evaluating the state of the battery comprises comparing the differential voltage to a first voltage threshold, and evaluating the state of the battery as being in the recoverable state if the differential voltage fulfills the criterion: first voltage threshold <= differential voltage < 2* first voltage threshold.

In one embodiment, evaluating the state of the battery further comprises comparing the first voltage amplitude to a second voltage threshold, and evaluating the state of the battery as being in the normal state if the differential voltage and the first voltage amplitude fulfills the criteria: differential voltage < first voltage threshold, and first voltage amplitude > second voltage threshold.

In one embodiment, evaluating the state of the battery further comprises comparing the first voltage amplitude to a second voltage threshold, and evaluating the state of the battery as being in the damaged state if the differential voltage and the first voltage amplitude fulfills the criteria: differential voltage < first voltage threshold, and first voltage amplitude < second voltage threshold.

In one embodiment, if the state of the battery is evaluated as being in a recoverable state, then charging the battery based on the evaluated state comprises setting the first current amplitude to a fraction of the second current amplitude and repeating the method steps of the first aspect of the invention.

In one embodiment, the fraction of the second current amplitude is selected in the range of [1%-50%] or selected in the range of [10%-40%] or selected in the range of [20%-30%].

In one embodiment, if the state of the battery is evaluated as being in a normal state, then charging the battery based on the evaluated state comprises charging the battery in any of a bulk charge mode, an absorption charge mode or a float charge mode.

In one embodiment, if the state of the battery is evaluated as being in a damaged state, then charging the battery based on the evaluated state comprises halting charge of the battery and providing an error indication to the user.

According to a second aspect of the invention the object of the invention is achieved by a battery charger, the battery charger comprising: a processor, and a memory, said memory containing instructions executable by said processor, wherein said battery charger is configured to: measure a first voltage amplitude over poles of the battery, obtain a second voltage amplitude and a first current amplitude, control generation of a pulse within a cycle period to poles of the battery, the pulse having the second voltage amplitude and being limited by the first current amplitude, measure a third voltage amplitude and a second current amplitude at the end of the generated pulse, determine a differential voltage as a difference between the second voltage amplitude and the first voltage amplitude, evaluate a state of the battery as being in a damaged state, in a recoverable state, or in a normal state by evaluating the first voltage amplitude and the differential voltage, and charging the battery based on the evaluated state.

According to a third aspect of the invention the object of the invention is achieved by a computer program product comprising instructions which, when the program is executed by a computer, cause the computer to carry out the method according to the first aspect.

According to a fourth aspect of the invention the object of the invention is achieved by a computer-readable storage medium comprising instructions which, when executed by a computer, cause the computer to carry out the steps of the method according to the first aspect.Further applications and advantages of embodiments of the invention will be apparent from the following detailed description.

### Brief description of the drawings

**Fig. 1** shows an example illustrating conventional charging stages or charging modes of a battery during a process of charging a battery by a battery charger.
**Fig. 2** shows a battery charger configured to charge a battery according to one or more embodiments of the present disclosure.
**Fig. 3A-C** shows a pulse generated in the auto-recovery stage according to one or more embodiments of the present disclosure.
**Fig. 4A-B** shows zones used to evaluate states of the battery during the auto-recovery stage according to one or more embodiments of the present disclosure.
**Fig. 5** shows a flowchart of a method according to one or more embodiments of the present disclosure.
**Fig. 6** shows an example of measured voltage and current amplitudes when operating in the auto-recovery stage.
**Fig. 7** schematically illustrates a battery charger.
**Fig. 8** Illustrates results from field tests of a battery charger operating in the auto recovery stage described herein.
**Fig. 9** shows an example illustrating charging stages or charging modes according to the present disclosure.

### Detailed description

An "or" in this description and the corresponding claims is to be understood as a mathematical OR which covers "and" and "or", and is not to be understand as an XOR (exclusive OR). The indefinite article "a" in this disclosure and claims is not limited to "one" and can also be understood as "one or more", i.e., plural.

In the present disclosure the term "battery charger" denotes a smart charger comprising circuitry including processing resources.

In the present disclosure, the term "voltage amplitude" or "voltage" denotes a magnitude of a potential difference between a measured point and a reference potential, such as earth.

In the present disclosure, the term "current amplitude" denotes a magnitude of a measured electric current.

In the present disclosure the term "cycle period" denotes a time period including when a pulse signal is active and when the pulse signal is inactive, also referred to as "period".

The expressions "processor" and "processing means" are used interchangeably within this disclosure.

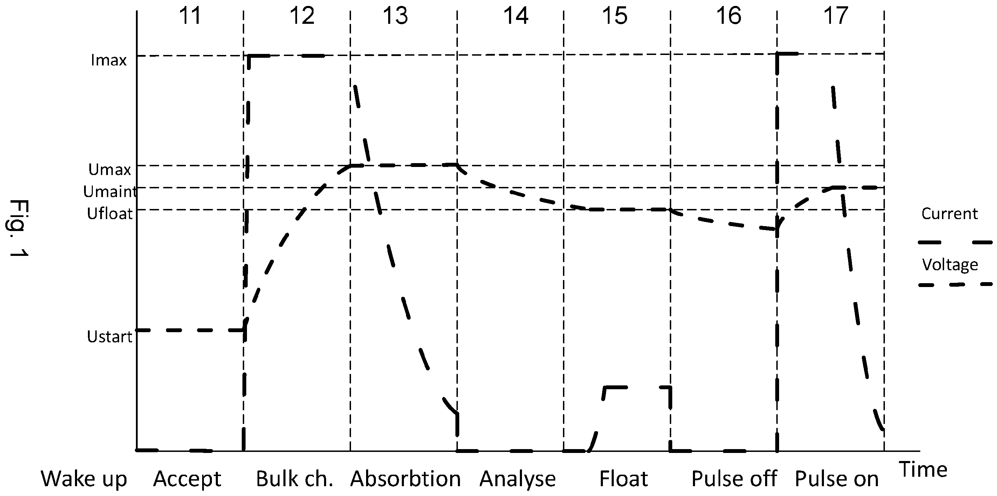

**Fig. 1** shows an example illustrating conventional charging stages or charging modes of a battery during a process of charging a battery by a battery charger. In other words, how a multimode smart charger may operate today.

The charging states 11-17 over time may be represented by the diagram in Fig. 1.

As can be understood, the time required to charge the battery also depends on the charging current provided to the battery.

Initially the charging process of the battery is in an acceptance stage 11, where the terminal battery voltage relatively slowly increases from relatively low voltage closer to a nominal voltage over the terminals of the battery. If any other behavior is observed, such as a relatively rapid increase in battery voltage, the battery is considered as being in a damaged state, charging is halted, and an error indication is typically provided to a user of the battery charger.

After the acceptance stage, the charging process of the battery is typically performed in a bulk charging stage 12, where the terminal battery voltage increases in a near linear manner. During the bulk charging stage 12, the battery charger is typically providing the highest available current, also referred to as constant current charging mode.

After the bulk charge mode, the charging continues in further charging modes 13-17, such as absorption charging mode, Analyse mode and Float charging mode, etc.

This means that a conventional charger will in a matter of speaking, either accept or reject charging of the battery. A rejected battery will typically be seen as waste and as a financial loss or cost.

Alternatively, if the battery is in a deeply discharged state, the charging may sometimes proceed to the bulk stage 12, and relatively quickly proceed to the later stages 13.-17 without increasing the charging level or SoC. In other words, not accept charge.

The present disclosure aims to improve the charging process by introducing an auto-recovery stage, where previously rejected batteries can be revived and the associated financial losses or operational costs are avoided.

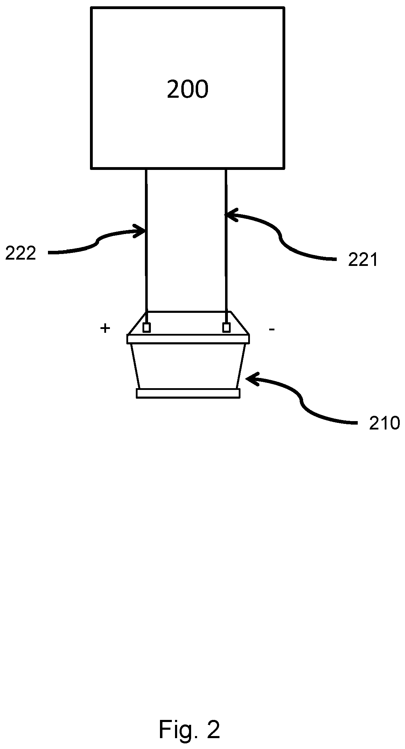

**Fig. 2** shows a battery charger 200 configured to charge a battery 210 according to one or more embodiments of the present disclosure.

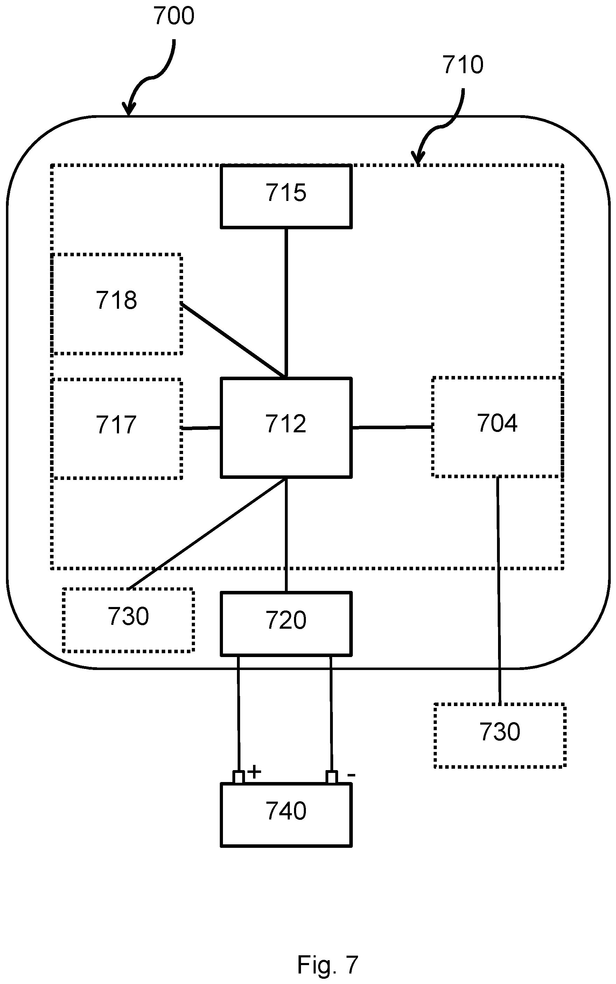

The battery charger 200 includes circuitry, such as a control unit communicatively coupled to a controllable power source or voltage/current generator. The control unit is configured to perform the methods described herein. The circuitry is further described in relation to Fig. 7.

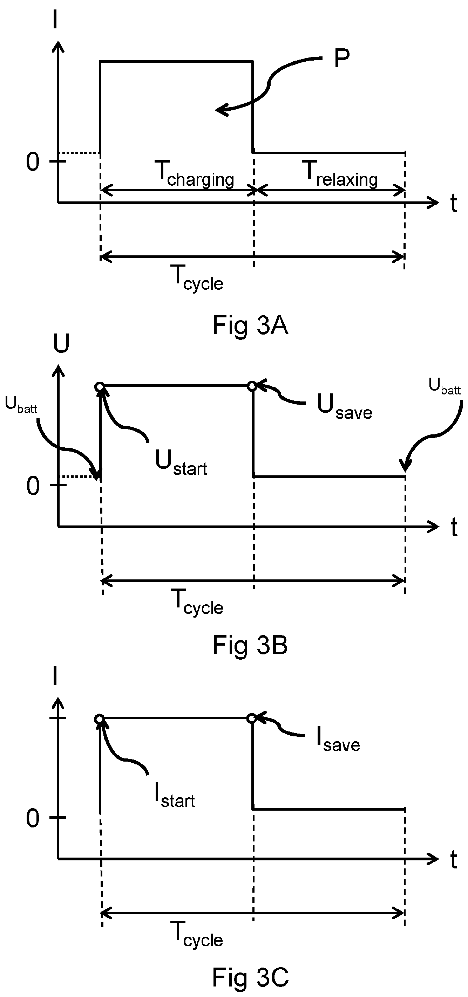

In one example, the control unit controls the power source to generate pulses having a voltage amplitude and/or a current amplitude. Generated pulses are further described in relation to Fig. 3A-Fig. 3C.

The battery charger 200 includes fixed or detachable conductors, 221, 222, e.g., charging cables with clamps. The conductors are typically configured to provide energy from the battery charger 200 to the battery 210 via positive and negative poles of the battery 210.

The battery charger 200 disclosed herein is, e.g., in addition to the stages shown in relation to Fig. 1, configured to operate in an auto-recovery stage or mode, activated when acceptance stage 11 indicates that the battery 210 is in a damaged state. In other words, the charger 200 performs an evaluation to determine if the battery is in a recoverable state.

As mentioned previously, the present disclosure aims to improve the acceptance rate of deeply discharged batteries by introducing an auto-recovery stage, where previously rejected batteries can be revived and the associated environmental, financial, or operational costs can be avoided.

**Fig. 3A** shows a pulse generated in the auto-recovery stage according to one or more embodiments of the present disclosure. In other words, after evaluating that the battery is in a recoverable state.

Fig. 3A shows a diagram showing current amplitude on the vertical axis and time on the horizontal axis.

The battery charger is typically configured to generate a pulse P to poles of the battery within a cycle period T_{cycle}. The cycle period T_{cycle} comprises a charging interval T_{charging} and a relaxing interval T_{relaxing}.

The cycle period T_{cycle}, the charging interval T_{charging} and the relaxing interval T_{relaxing} can be seen as associated pulse characteristics of the pulse P.

**Fig. 3B** shows details of the pulse generated in the auto-recovery stage according to one or more embodiments of the present disclosure. In other words, a pulse generated after evaluating that the battery 201 is in a recoverable state.

The generated pulse P has further associated pulse characteristics. Figure 3B shows an initial voltage amplitude Uₛₜₐᵣₜ at the start of the generated pulse and a measured voltage amplitude Uₛₐᵥₑ at the end of the generated pulse.

At the end of the relaxing interval T_{relaxing}, also at the end of the cycle period T_{cycle}, a voltage amplitude U_{batt} is measured by the disclosed method.

In Fig. 3B the initial voltage amplitude Uₛₜₐᵣₜ and the measured voltage amplitude Uₛₐᵥₑ of the pulse are shown as having the same amplitude for illustrative purposes. However, it is understood that in a real-world scenario they will in most cases be different.

A voltage difference U_{delta}, may be then be determined or calculated as Uₛₐᵥₑ - U_{batt}. In embodiments, the voltage difference U_{delta} may be then be determined or calculated as an absolute value |Uₛₐᵥₑ - U_{batt}|.

**Fig. 3C** shows details of the pulse generated in the auto-recovery stage according to one or more embodiments of the present disclosure. In other words, after evaluating that the battery is in a recoverable state.

The generated pulse P has further associated pulse characteristics. Figure 3C shows an initial current amplitude Iₛₜₐᵣₜ and a measured current amplitude Iₛₐᵥₑ at the end of the generated pulse.

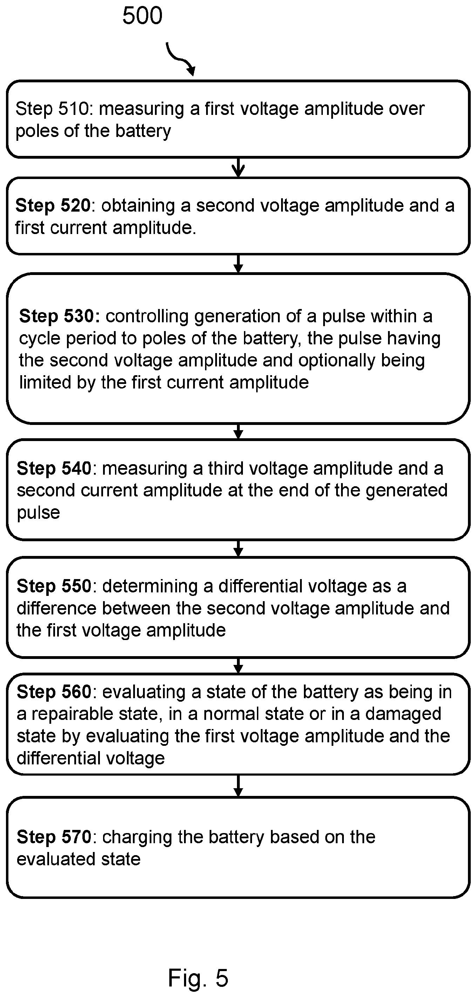

A system parameter Iₘₐₓ may be set, that sets a maximum current that effectively limits the maximum current output of the controllable power source of the charger 200. In a similar manner, the initial current amplitude Iₛₜₐᵣₜ limits the current output of the controllable power source of the charger 200. The initial current amplitude Iₛₜₐᵣₜ may be set to Iₘₐₓ in a first pulse in the auto-recovery stage, and later to a fraction of Iₘₐₓ in subsequent pulses, as further described in relation to Fig. 5.

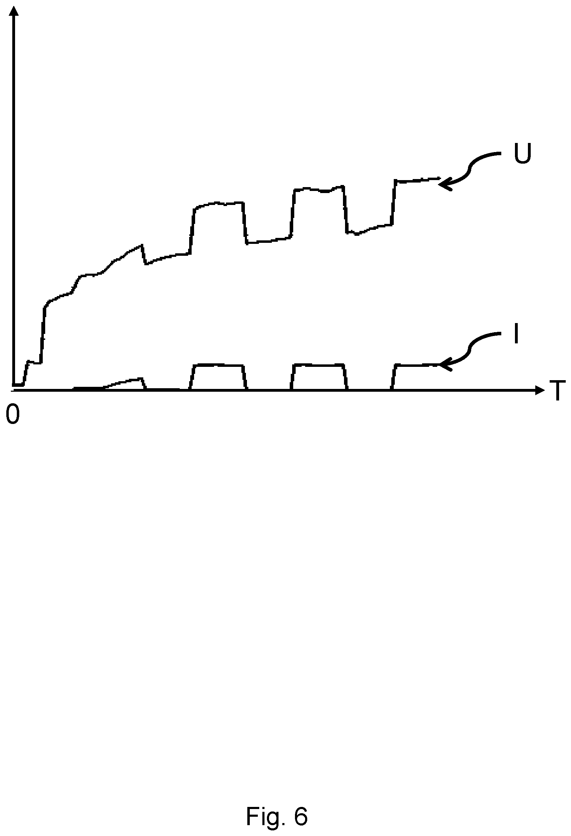

In many cases, it will be the battery itself, or rather the battery chemistry, that effectively limits the maximum charging current accepted by the charged battery, as is illustrated in relation to Fig. 6. In other words, even if the output of the controllable power source is limited to the initial current amplitude Iₛₜₐᵣₜ, the battery will only accept a smaller current than the initial current amplitude Iₛₜₐᵣₜ.

In Fig. 3B the initial current amplitude Iₛₜₐᵣₜ and a measured current amplitude Iₛₐᵥₑ of the pulse P are shown as having the same amplitude for illustrative purposes. However, it is understood that in a real-world scenario they will in most cases be different.

In the present disclosure, when the battery charger is operating in the auto-recovery stage, the state of the battery 210 is periodically evaluated, e.g., after each generated pulse P, as shown in relation to Fig. 3A.3C.

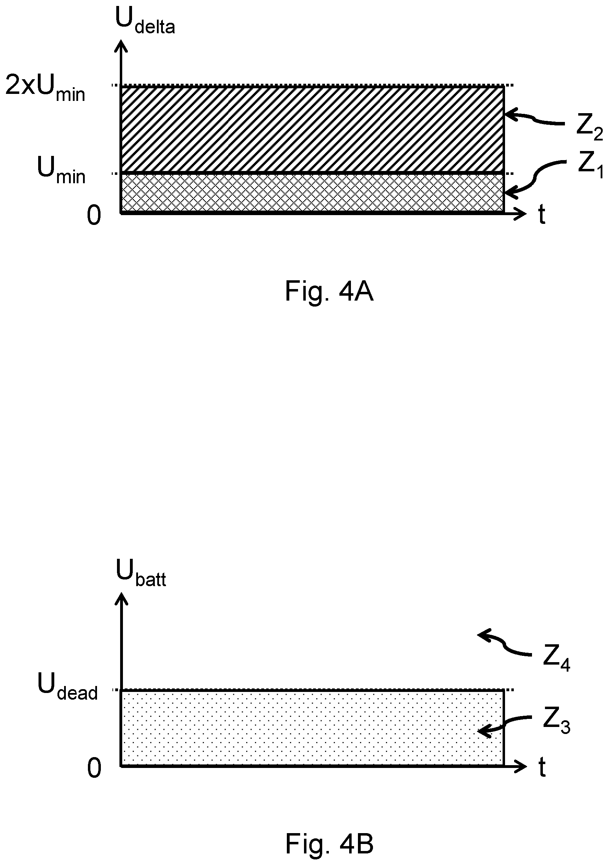

**Fig. 4A** illustrates zones used to evaluate a state of the battery during the auto-recovery stage according to one or more embodiments of the present disclosure. In other words, after evaluating that the battery is in the recoverable state.

The voltage difference U_{delta} may be used to evaluate the state of the battery 210. As mentioned, the voltage difference U_{delta} may be determined/calculated as Uₛₐᵥₑ - U_{batt} or as an absolute value thereof.

A zone Z₁ may be defined between U_{delta} = 0 V and less than a voltage threshold Uₘᵢₙ. The voltage threshold Uₘᵢₙ may in one example be set within a range of [2-6%] of the nominal voltage of the battery 210.

A zone Z₂ may be defined between the voltage threshold Uₘᵢₙ and 2* the voltage threshold Uₘᵢₙ , or as 2* Uₘᵢₙ >U_{delta} >= Uₘᵢₙ.

In other words, Z₁ and Z₂ may be used to evaluate U_{delta} and the state of the battery 210.

**Fig. 4B** shows further zones used to evaluate the state of the battery during the auto-recovery stage according to one or more embodiments of the present disclosure. In other words, after evaluating that the battery is in the recoverable state.

Before generation of the pulse during the auto-recovery stage, shown in relation to Fig 3A-3C, a voltage amplitude U_{batt} over poles of the battery 210 is measured, e.g., at the end of the relaxing interval T_{relaxing}.

The measured voltage amplitude U_{batt} may then be used to evaluate the state of the battery 210.

A zone Z₃ may be defined between U_{batt} = 0 V and U_{batt} < U_{dead}, where U_{dead} is a voltage threshold. The voltage threshold U_{dead} may in one example be set within a range of [10-20%] of the nominal voltage of the battery 210. Nominal voltage may be the rated Open Circuit Voltage, OCV, of the battery 210.

A zone Z₄ may be defined as U_{batt} >= U_{dead}.

In other words, Z₃ and Z₄ may be used to evaluate U_{batt} and the state of the battery 210.

In some embodiments, the evaluation is only performed if the evaluation remains stable over a time period or particular time period, e.g., 5 seconds.

With relation to Fig. 4A and Fig. 4B, examples of evaluating the state of the battery is shown below:
In this example, it is determined that the voltage difference U_{delta} falls in the zone Z₂. In other words, the difference fulfils the criterion U_{delta} >= Uₘᵢₙ. The state of the battery 210 can then be evaluated as being in a recoverable state and the battery 210 continues to be charged in the auto-recovery stage.

In a further example, it is determined that the voltage difference U_{delta} falls in the zone Z₁. In other words, the voltage difference fulfils the criterion U_{delta} < Uₘᵢₙ. It is further determined that the measured voltage amplitude U_{batt} falls in the zone Z₄. In other words, fulfils the criterion U_{batt} >= U_{dead} . The state of the battery 210 can then be evaluated as being in a normal state, and charging in any of the charging stages 12-17 shown in Fig. 1 may begin, e.g., bulk charging 12.

In yet a further example, it is determined that the voltage difference U_{delta} falls in the first zone Z₁. In other words, the voltage difference fulfils the criterion U_{delta} < Uₘᵢₙ. It is further determined that the measured voltage amplitude U_{batt} falls in the zone Z₃. In other words, fulfils the criterion U_{batt} < U_{dead} . The state of the battery 210 can then be evaluated as being in a damaged state and charging is halted. Optionally, an indication is provided to a user of the battery charger 200.

It may be seen as that the zones Z₁ to Z₄ are used to evaluate the state of the battery. If the voltage difference U_{delta} falls in the zone Z₂, the battery 210 is evaluated as being in a recoverable state. If the voltage difference U_{delta} falls in the zone Z₁, the battery 210 is evaluated as being in either the normal state or the damaged state. The measured voltage amplitude U_{batt} is then used to separate the normal state from the damaged state. I.e., If U_{batt} falls in the zone Z₄, the battery is evaluated as being in the normal state. I.e., If U_{batt} falls in the zone Z₃, the battery is evaluated as being in the damaged state.

**Fig. 5** shows a flowchart of a method 500 according to one or more embodiments of the present disclosure. The A method is performed by a battery charger 200, or a control unit of the battery charger 200, configured to charge a battery 210, the method comprising:
**Step 510:** measuring a first voltage amplitude U_{batt} over poles of the battery 210.

The first voltage amplitude U_{batt} is measured at the end of the relaxing interval T_{relaxing}.

In one example, the voltage amplitude U_{batt} over poles of the battery 210 is obtained from a voltage sensor at the output port or output conductors 221, 222 of the battery charger 200. The voltage amplitude U_{batt} is typically measured without load connected to the battery, so that an Open Circuit Voltage, OCV, can be measured.

**Step 520:** obtaining a second voltage amplitude Uₛₜₐᵣₜ and a first current amplitude Iₛₜₐᵣₜ.

In one example, values for Uₛₜₐᵣₜ and Iₛₜₐᵣₜ are stored in memory of the control unit and/or battery charger and are obtained by retrieving them from the memory.

In one example, values for Uₛₜₐᵣₜ and Iₛₜₐᵣₜ are stored in memory of an external unit or server charger and are obtained by retrieving a message or control signal from the external unit.

**Step 530:** controlling generation of a pulse within a cycle period T_{cycle} to poles of the battery 210, the pulse having the second voltage amplitude Uₛₜₐᵣₜ and optionally being limited by the first current amplitude Iₛₜₐᵣₜ.

Under practical circumstances, the current is actually limited by the battery's ability to accept the charging current.

In one example, Iₛₜₐᵣₜ is initially set to Iₘₐₓ. When U_{diff} enters Z₂ Iₛₜₐᵣₜ is reduced to a fraction of Iₘₐₓ, e.g., 25% of Iₘₐₓ. The fraction may e.g., be selected in the range of [1%-50%] or selected in the range of [10%-40%] or selected in the range of [20%-30%].

The pulse is typically generated by the controllable power source of the battery charger.

**Step 540:** measuring or obtaining a third voltage amplitude Uₛₐᵥₑ and a second current amplitude Iₛₐᵥₑ at the end of the generated pulse.

In one example, the voltage amplitude Uₛₐᵥₑ is measured by obtaining measurements from a voltage sensor and Iₛₐᵥₑ is measured by obtaining measurements from a current sensor of the battery charger 200.

In one embodiment, it is further determined that the second current amplitude Iₛₐᵥₑ is below a minimum current threshold Iₘᵢₙ, and the steps 510-540 are repeated with , Iₛₜₐᵣₜ set to Iₘₐₓ.

**Step 550:** determining a differential voltage U_{delta} as a difference between the second voltage amplitude Uₛₐᵥₑ and the first voltage amplitude U_{batt}.

**Step 560:** evaluating a state of the battery as being in a recoverable state, in a normal state or in a damaged state by evaluating the measured voltage U_{batt} and the differential voltage U_{delta}.

Evaluation of the state of the battery 210 is further described in relation to Fig. 4.

**Step 570:** charging the battery 210 based on the evaluated state.

In embodiments, the above steps 510-570 are repeated until the battery is evaluated as being in the normal state and charging in any of the stages 12-17 shown in Fig. 1 is performed, or evaluated as being in the damaged state and charging is halted.

In embodiments, the evaluation may e.g., result in the battery being in the recoverable state, and charging the battery 210 based on the evaluated state involves operating the battery charger in the auto recovery stage.

In this embodiment, evaluating the state of the battery as being in the recoverable state comprises comparing the differential voltage U_{delta} to a first voltage threshold Uₘᵢₙ, and evaluating the state of the battery as being in the recoverable state if the differential voltage U_{delta} fulfills the criterion:$first voltage threshold \left({U}_{min}\right) < = differential voltage \left({U}_{delta}\right) < 2 * first voltage threshold \left({U}_{min}\right) .$

This is also illustrated as zone Z₂ in relation to Fig. 4.

In this embodiment, if the state of the battery is evaluated as being in a recoverable state, then charging the battery based on the evaluated state further comprises setting the first current amplitude Iₛₜₐᵣₜ to a fraction of the second current amplitude Iₛₜₐᵣₜ and repeating at least the method steps 510-550.

Under practical circumstances, the current is actually limited by the battery's ability to accept the charging current.

In one embodiment, the fraction of the second current amplitude Iₛₜₐᵣₜ is selected in the range of 1%-50% or selected in the range of 10%-40% or selected in the range of 20%-30%.

Alternatively, the evaluation may e.g., result in the battery being in the normal state, and charging the battery based on the evaluated state involves operating the battery charger in any of the stages 13-17 shown in Fig. 1.

In this embodiment, evaluating the state of the battery further comprises comparing the first voltage amplitude U_{batt} to a second voltage threshold U_{dead}, and evaluating the state of the battery as being in the normal state if the differential voltage U_{delta} and the first voltage amplitude U_{batt} fulfills the criteria: 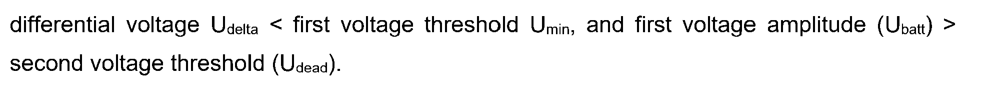 differential voltage Udelta < first voltage threshold Umin, and first voltage amplitude (Ubatt) > second voltage threshold (Udead).

In one embodiment, if the state of the battery is evaluated as being in a normal state, then charging the battery based on the evaluated normal state comprises charging the battery 210 in any of a bulk charge mode, an absorption charge mode or a float charge mode, or any other mode 13-17 shown in relation to Fig. 1.

Alternatively, the evaluation may e.g., result in the battery being in the damaged state, and charging the battery based on the evaluated state involves halting charging and indicating this to a user of the battery charger.

In this embodiment, evaluating the state of the battery further comprises comparing the first voltage amplitude U_{batt} to a second voltage threshold U_{dead}, and evaluating the state of the battery as being in the damaged state if the differential voltage U_{delta} and the first voltage amplitude U_{batt} fulfills the criteria: 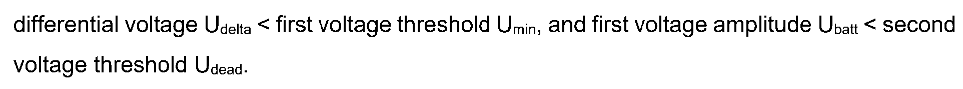 differential voltage Udelta < first voltage threshold Umin, and first voltage amplitude Ubatt < second voltage threshold Udead.

This is also illustrated as zones Z₁ and Z3 in relation to Fig. 4.

In one embodiment, if the state of the battery is evaluated as being in a damaged state, then step of charging the battery based on the evaluated state comprises halting charge of the battery and providing an error indication to the user.

**Fig. 6** shows an example of voltage over the poles of the battery when operating in the auto-recovery stage.

Fig. 6 shows a diagram with time on the horizontal axis and amplitude, both voltage and current, om the vertical axis.

The voltage U over the poles of the battery is shown as a curve.

The current I delivered to the battery is shown as a further curve.

In an exemplary scenario, the acceptance stage indicates that the charged battery is rejected. In other words, that the battery is incapable of receiving charge and should be discarded.

After evaluating the state of the battery as being in a recoverable state, the auto-recovery stage is then initiated, and a first or initial pulse is provided to poles of the battery. As described earlier, this first or initial pulse is limited to Iₛₜₐᵣₜ or Iₘₐₓ by the charger. Iₘₐₓ is effectively limited by a maximum charging voltage Uₘₐₓ, which is typically limited by a rated maximum voltage of vehicles, e.g., 16 volts for vehicles using a 12 Volt system.

Effectively, the chemistry of the battery sets the real-world limitation of the current. As can be seen in Fig. 6, the current of the first or initial pulse at time = 0 is close to zero.

As described earlier, this second and subsequent pulse is typically limited to a fraction of Iₘₐₓ by the charger, e.g., to 25% of Iₘₐₓ.

Allready at the third and subsequent pulse, the voltage has climbed significantly. Also, the current amplitude has increased to a level wherein it can be said that the battery is accepting charge.

The charger will then operate in the recoverable state for a substantial amount of time before switching to the normal state and charge the battery, e.g., in the bulk charging mode.

This is further described in relation to Fig. 1.

**Fig. 7** schematically illustrates a battery charger 700. Fig. 7 further illustrates a battery 740 and an optional voltage sensor 730 according to an embodiment of the present invention. The battery 740 may in an embodiment be configured for use in a craft or vehicle.

The battery 740 may e.g., serve as a battery of a vehicle. The battery charger 700 may be configured to monitor the battery 740, e.g. to monitor one or more of a charging/discharging current or a battery voltage or a battery capacity or a state-of-charge value. The battery charger 700 may be configured with a voltage sensor 730.

The voltage sensor 730 may be configured to be coupled or to be couplable to the terminals/poles of the battery 740. The voltage sensor 730 may be arranged internally to the battery charger 700, externally to the battery charger 700 or comprised in an external unit communicatively coupled to the battery charger 700. In Fig. 7, both the internally and externally configurations are shown. The voltage sensor 730 may be configured to measure voltage values and send the measured voltage values to the battery charger 700, e.g. via wired communication or wireless communication. The wired communication may be performed e.g. using Modbus, Controller Area Network, Local Interconnect Network, Universal Asynchronous Receiver/Transmitter, Serial Peripheral Interface, or I2C (Inter Integrated Circuit protocol). Wireless communication may be performed e.g. using Bluetooth, WiFi, 3G, 4G, 5G etc. The voltage sensor 730 may also or alternatively be configured to store measured voltage amplitude and/or current amplitude values to memory, e.g. for intermediate storage before sending them to the charger or any other unit.

Optionally, the battery charger 700 further comprises a current sensor (not shown), with similar capabilities as the voltage sensor.

The battery charger 700 may comprise a processor or processing means 712. Further, the battery charger 700 may further comprise a transceiver 704 for wired or wireless communication and communicatively coupled to the processor 712. Further, the battery charger 700 may further comprise at least one optional antenna (not shown). The antenna may be coupled to the transceiver 704 and is configured to transmit or emit or receive wired or wireless signals, e.g. in a wireless communication system. The wired or wireless signals may comprise the first/second plurality of successive voltage values as a wired or wireless signal. In one example, the processor 712 may be any of processing circuitry and/or a central processing unit and/or processor modules and/or multiple processors configured to cooperate with each-other.

Further, the battery charger 700 may comprise a memory 715 communicatively coupled to the processor 712. The memory 715 may contain instructions executable by the processor to perform the methods described herein. The battery charger 700 may be configured to receive data, such as the plurality of successive voltage values, directly from the voltage sensor 730 or via the wired and/or wireless communications network or to retrieve them from memory.

The battery charger 700 may further comprise a power source 720 or signal generator electrically couplable to terminals of the battery and communicatively coupled to the processor 712, either directly via the transceiver 704 or via the wireless communications network. The power source 720 is further configured to generate a current pulse P within a cycle period T_{cycle} in response to a control signal, e.g. received from the processor 712 via wired or wireless communication. The pulse is further described in relation to Fig. 3A-C. The power source 720 may be configured to generate the pulse once or cyclically/repeatedly after receiving the control signal. The pulse is typically generated to terminals of the battery 740, when connected thereto. The power source 720 may be arranged internally or externally to the battery charger, e.g. as an integral power source of the battery charger or a power source being external to the battery charger.

The transceiver 704 may be configured to send and/or receive data values or parameters as a signal to or from the processing means 712 or to or from other external nodes, i.e. between the voltage sensor 730 and the battery charger 700 or from the processing means 712 to a server. In an embodiment, the transceiver 704 communicates directly to other external nodes or via the communications network.

In one or more embodiments the battery charger 700 may further comprise an input device 717, configured to receive input or indications from a user and send a user-input signal indicative of the user input or indications to the processing means 712.

In one or more embodiments the battery charger further comprises a display 718 configured to receive a display signal indicative of rendered objects, such as text or graphical user input objects, from the processing means 712 and to display the received signal as objects, such as text or graphical user input objects.

In one embodiment the display 718 is integrated with the user input device 717, e.g. as a touch display, and is configured to receive a display signal indicative of rendered objects, such as text or graphical user input objects, from the processing means 712 and to display the received signal as objects, such as text or graphical user input objects, and/or configured to receive input or indications from a user and send a user-input signal indicative of the user input or indications to the processing means 712.

In an embodiment, the battery charger comprises a control unit 710 communicatively separate from and coupled to the power source 720. The control unit 710 may comprise the processing means 712, the memory 715 and the transceiver 704. Optionally the control unit 710 may further comprise the user input device 717 or the display 718.

The control unit 710 may be in the form of an electronic control unit, ECU, a microcontroller unit MCU, a server, an on-board computer, a stationary computing device, a laptop computer, a tablet computer, a handheld computer, a wrist-worn computer, a smart watch, a PDA, a Smartphone, a smart TV, a telephone, a vehicle mounted computer system or a navigation device.

In embodiments, the processing means 712 is communicatively coupled to a selection of any of the memory 715 or the transceiver 704 or the input device 717 or the display 718 or the power source 720 or the voltage sensor 730.

In embodiments, the transceiver 704 communicates using wired or wireless communication techniques known in the art, e.g. Universal Serial Bus USB or Bluetooth.

In embodiments, the one or more memory 715 may comprise a selection of Random Access Memory RAM, Read-Only Memory ROM, a Programmable Read-Only Memory PROM, an Erasable PROM EPROM, Electrically Erasable PROM EEPROM, a flash drive, a disk drive, a floppy disk drive, an optical disk drive, a CD or DVD drive (R or RW), or other removable or fixed media drive.

In a further embodiment, the battery charger 700 may further comprise one or more additional sensors configured to receive and/or obtain and/or measure physical properties pertaining to the battery charger 700 or the battery 740 and send one or more sensor signals indicative of the physical properties to the processing means 712. In one example, the physical properties comprises electrical current flowing to or from the battery. In one further example, the physical properties comprise ambient temperature.

In an embodiment, a computer program comprising computer-executable instructions for causing a battery charger 700 when the computer-executable instructions are executed on at least one processing circuit comprised in the battery charger 700, to perform the method described herein.

In an embodiment, a program product comprising a computer-readable storage medium, the computer-readable storage medium having the computer program above embodied therein.

In embodiments, the communication may include using at least one of a Local Area Network (LAN), Metropolitan Area Network (MAN), Global System for Mobile Network (GSM), Enhanced Data GSM Environment (EDGE), Universal Mobile Telecommunications System, Long term evolution, High Speed Downlink Packet Access (HSDPA), Wideband Code Division Multiple Access (W-CDMA), Code Division Multiple Access (CDMA), Time Division Multiple Access (TDMA), Bluetooth^{®}, Zigbee^{®}, Wi-Fi, Voice over Internet Protocol (VoIP), LTE Advanced, IEEE802.16m, WirelessMAN-Advanced, Evolved High-Speed Packet Access (HSPA+), 3GPP Long Term Evolution (LTE), Mobile WiMAX (IEEE 802.16e), Ultra Mobile Broadband (UMB) (formerly Evolution-Data Optimized (EV-DO) Rev. C), Fast Low-latency Access with Seamless Handoff Orthogonal Frequency Division Multiplexing (Flash-OFDM), High Capacity Spatial Division Multiple Access (iBurst^{®}) and Mobile Broadband Wireless Access (MBWA) (IEEE 802.20) systems, High Performance Radio Metropolitan Area Network (HIPERMAN), Beam-Division Multiple Access (BDMA), World Interoperability for Microwave Access (Wi-MAX) and ultrasonic communication, etc., but is not limited thereto.

Especially, the processing means of the battery charger may comprise processing means, e.g., one or more instances of processing circuitry, processor modules and multiple processors configured to cooperate with each-other, Central Processing Unit (CPU), a processing unit, a processing circuit, a processor, an Application Specific Integrated Circuit (ASIC), a microprocessor, a Field-Programmable Gate Array (FPGA) or other processing logic that may interpret and execute instructions. The expression "processing means" may thus represent a processing circuitry comprising a plurality of processing circuits, such as, e.g., any, some or all of the ones mentioned above. The processing means may further perform data processing functions for inputting, outputting, and processing of data comprising data buffering and device control functions, such as call processing control, user interface control, or the like.

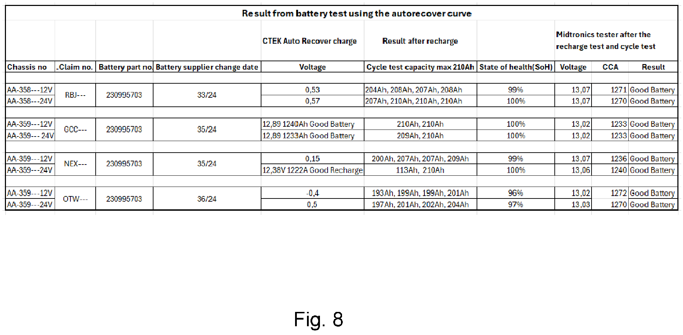

**Fig. 8** Illustrates results from field tests of the auto recovery stage.

The example shows 8 batteries that was returned as faulty, and then were charged using the recovery stage described herein. The result was that all the batteries that otherwise would be discarded, were instead returned to good health. This represents significant savings for the environment as well as saving of operational costs.

The table show chassis number, claim number, date of initial use, OCV at arrival, Capacity after recovery, State of Health after recovery, OCV after recovery, cold cranking amps after recovery and result.

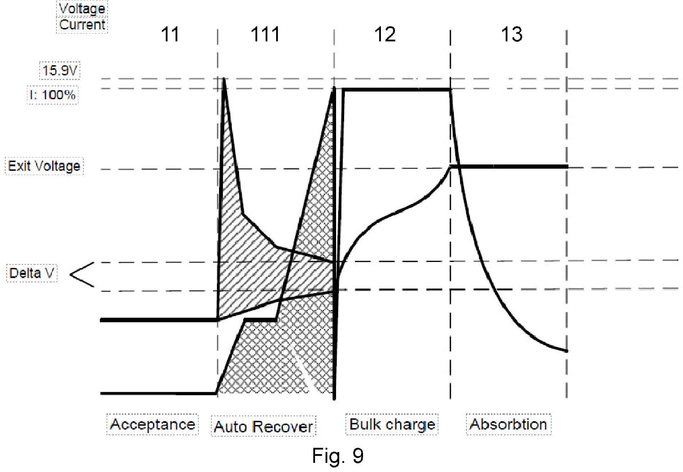

**Fig. 9** shows an example illustrating charging stages or charging modes according to the present disclosure.

Initially the charging process of the battery is in an acceptance stage 11, where it is determined that the battery is in a damaged state.

In conventional chargers this would result in an error being indicated to a user of the battery charger or that the charging would finish relatively quickly without increasing the charging level of the battery.

In the present disclosure, the auto recovery stage 111 is instead initiated.

Fig. 9 shows battery voltage (hashed area) and charging current or current flowing to the battery (checkered area).

As can be seen the charging voltage is initially high, and then drops in the auto recovery stage. In one example, the initial charging voltage in the auto recovery stage is set just below a maximum voltage defined by vehicle electronics maximal supported voltage, e.g., 16 Volts. The charging current is initially low, and increases over time.

In one example, the present disclosure of the battery charger operating in the auto-recovery stage is illustrated.

Here the battery voltage is fast rising from close to 0V to more that 4V in the time interval from 0 minutes to approximately 40 minutes while also the current amplitude of the pulses are increasing.

Then the current is limited to Imax/4 while the voltage U_{batt} is rising with the U_{delta} in the interval > Uₘᵢₙ but < 2*Uₘᵢₙ.at a time of approximately 500minutes, U_{delta} becomes < Uₘᵢₙ (zone Z₁) and the current amplitude is increased to Iₘₐₓ. It continues until U_{delta} again is < Uₘᵢₙ at T 3000 at which point the battery is repaired and normal bulk charging starts.

Finally, it should be understood that the invention is not limited to the embodiments described above, but also relates to and incorporates all embodiments within the scope of the appended independent claims.

## Claims

1. A method performed by a battery charger (200) configured to charge a battery (210), the method comprising:
measuring a first voltage amplitude (U_{batt}) over poles of the battery (210),
obtaining a second voltage amplitude (Uₛₜₐᵣₜ) and a first current amplitude (Iₛₜₐᵣₜ),
controlling generation of a pulse within a cycle period (T_{cycle}) to poles of the battery, the pulse having the second voltage amplitude (Uₛₜₐᵣₜ) and being limited by the first current amplitude (Iₛₜₐᵣₜ),
measuring a third voltage amplitude (Uₛₐᵥₑ) and a second current amplitude (Iₛₐᵥₑ) at the end of the generated pulse,
determining a differential voltage (U_{delta}) as a difference between the second voltage amplitude (Uₛₐᵥₑ) and the first voltage amplitude (U_{batt}),
evaluating a state of the battery as being in a recoverable state, in a normal state or in a damaged state by evaluating the first voltage amplitude (U_{batt}) and the differential voltage (U_{delta}), and
charging the battery (210) based on the evaluated state.

2. The method according to claim 1, wherein evaluating the state of the battery comprises comparing the differential voltage (U_{delta}) to a first voltage threshold (Uₘᵢₙ), and evaluating the state of the battery as being in the recoverable state if the differential voltage (U_{delta}) fulfills the criterion: 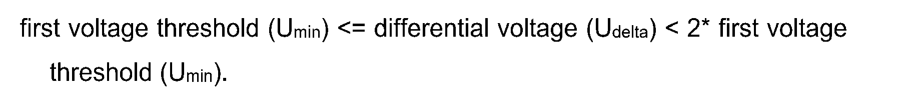 first voltage threshold (Umin) <= differential voltage (Udelta) < 2* first voltage threshold (Umin).

3. The method according to any of claims 1-2, wherein evaluating the state of the battery further comprises comparing the first voltage amplitude (U_{batt}) to a second voltage threshold (U_{dead}), and
evaluating the state of the battery as being in the normal state if the differential voltage (U_{delta}) and the first voltage amplitude (U_{batt}) fulfills the criteria:
differential voltage (U_{delta}) < first voltage threshold (Uₘᵢₙ), and
first voltage amplitude (U_{batt}) > second voltage threshold (U_{dead}).

4. The method according to any of claims 1-3, wherein evaluating the state of the battery further comprises comparing the first voltage amplitude (U_{batt}) to a second voltage threshold (U_{dead}), and
evaluating the state of the battery as being in the damaged state if the differential voltage (U_{delta}) and the first voltage amplitude (U_{batt}) fulfills the criteria:
differential voltage (U_{delta}) < first voltage threshold (Uₘᵢₙ), and
first voltage amplitude (U_{batt}) < second voltage threshold (U_{dead}).

5. The method according to any of the preceding claims, wherein if the state of the battery is evaluated as being in a recoverable state, then charging the battery based on the evaluated state comprises setting the first current amplitude (Iₛₜₐᵣₜ) to a fraction of the second current amplitude (Iₛₜₐᵣₜ) and repeating the method steps of claim 1.

6. The method according to claim 5, wherein the fraction of the second current amplitude (Iₛₜₐᵣₜ) is selected in the range of [1%-50%] or selected in the range of [10%-40%] or selected in the range of [20%-30%].

7. The method according to any of the preceding claims, wherein if the state of the battery is evaluated as being in a normal state, then charging the battery based on the evaluated state comprises charging the battery (210) in any of a bulk charge mode, an absorption charge mode or a float charge mode.

8. The method according to any of the preceding claims, wherein if the state of the battery is evaluated as being in a damaged state, then charging the battery based on the evaluated state comprises halting charge of the battery and providing an error indication to the user.

9. A battery charger (200), the battery charger comprising:
a processor, and
a memory, said memory containing instructions executable by said processor, wherein said battery charger is configured to:
measure a first voltage amplitude (U_{batt}) over poles of the battery (210),
obtain a second voltage amplitude (Uₛₜₐᵣₜ) and a first current amplitude (Iₛₜₐᵣₜ),
control generation of a pulse within a cycle period (T_{cycle}) to poles of the battery, the pulse having the second voltage amplitude (Uₛₜₐᵣₜ) and being limited by the first current amplitude (Iₛₜₐᵣₜ),
measure a third voltage amplitude (Uₛₐᵥₑ) and a second current amplitude (Iₛₐᵥₑ) at the end of the generated pulse,
determine a differential voltage (U_{delta}) as a difference between the second voltage amplitude (Uₛₐᵥₑ) and the first voltage amplitude (U_{batt}),
evaluate a state of the battery as being in a damaged state, in a recoverable state, or in a normal state by evaluating the first voltage amplitude (U_{batt}) and the differential voltage (U_{delta}), and
charging the battery (210) based on the evaluated state.

10. A computer program product comprising instructions which, when the program is executed by a computer, cause the computer to carry out the method according to any of claims 1-8.

11. A computer-readable storage medium comprising instructions which, when executed by a computer, cause the computer to carry out the steps of the method according to any of claims 1-8.
